# EUROPEAN PATENT APPLICATION

(11) **EP 1 873 584 A1**
(43) Date of publication of application: **02.01.2008**
(21) Application number: 06746776.1
(22) Date of filing: 24.05.2006
(51) Int. Cl.: G03B 21/28, C23C 14/02, G02B 5/08

(54) **FRONT SURFACE MIRROR**

(30) Priority: 02.06.2005 JP 2005163260
(71) Applicant: CENTRAL GLASS COMPANY, LIMITED, Ube-shi, Yamaguchi-ken 755-0001 (JP)
(72) Inventor: ONISHI, Tadashi Matsuzaka Plant of CENTRAL GLASS COMPANY LIMITED, Matsuaka-shi, Mie 515-0001 (JP); KITAGAWA, KITAGAWA Matsuzaka Plant of CENTRAL GLASS COMPANY LIMITED, Tokyo 101-0054 (JP); UENO, Yasushi Matsuzaka Plant of CENTRAL GLASS COMPANY LIMITED, Matsuaka-shi, Mie 515-0001 (JP); MIYAMOTO, Minoru Matsuzaka Plant of CENTRAL GLASS COMPANY LIMITED, Matsuaka-shi, Mie 515-0001 (JP)
(74) Representative: Thul, Stephan
(86) International application number: PCT/JP2006/310293
(87) International publication number: WO 2006/129528

(57) **Abstract**

In a front surface mirror used for a rear projection television, in which a metal film and a metal oxide film are formed on a glass substrate in this order, the front surface mirror being **characterized in that** a surface of the glass substrate is reformed by ion etching and that the metal film is an Al film.

## Description

### TECHNICAL FIELD

The present invention relates to a front surface mirror that is formed of a metal film and an oxide film and that is for use in a rear projection television, in which image is projected from the back surface of the screen.

### BACKGROUND OF THE INVENTION

In recent years, there have been apparatuses for conducting a large screen display, such as rear projection television, flat panel display and projection television, for a large screen display. In particular, rear projection television has spread considerably due to the reason that it has a low price.

Rear projection television is one in which a display screen of CRT or the like is projected onto the screen using an optical system. The display light is reflected by using a mirror and is projected onto a large screen by extending the optical path with a shallow depth.

As mirrors used for rear projection televisions, there are used a so-called back surface mirror that is produced by forming an Ag film on a glass substrate by a silver mirror reaction and by forming a protective film on the Ag film, and a front surface mirror that is produced by forming a metal film on the front surface of glass and by forming an oxide film thereon and that light is incident on the surface of the oxide film and is reflected from the metal film.

The back surface mirror is superior in durability to the extent that it can be used in a bath room or the like, since the reflective film is protected by using a durable protective film. However, light is also reflected from the glass surface, besides it is reflected from the Ag film. Therefore, there are a problem of the occurrence of a double image of a display projected on the screen, and a problem of low reflectance due to the absorption of the display light by the glass substrate.

In the front surface mirror, the display light is directly incident, without the transmission through the glass, on and reflected from a metal film formed on the glass surface by physical vapor deposition method or the like. Therefore, it does not have a problem of double image and is also high in reflectance.

For example, Patent Publication 1 discloses a front surface mirror in which a metal film containing Ag as a main component and Pd, Au and Ru added thereto is prepared by sputtering method.

However, such mirror is too expensive by the use of noble metals to be used for a rear projection television for general home uses. Furthermore, it has a problem in durability against a high temperature, high humidity atmosphere.

Therefore, a front surface mirror using Al for the metal film has been used recently. For example, Patent Publication 2 proposes a reflective mirror in which thin films have been formed on the substrate in the order of TiO₂, AlO₂, Al and TiO₂, as a front surface mirror using Al. This front surface mirror has a reflectance of 90% or lower and has a drawback in hardness of the reflective film.

Furthermore, Patent Publication 3 proposes a reflective mirror in which thin films have been formed in the order of SiO₂, Al, Cr and Al₂O₃. Reflectance of this front surface mirror is also low, and therefore it cannot be used for rear projection mirrors.

Thus, a reflective mirror of a reflectance-increased type, in which films have been formed on the glass substrate in the order of Al, SiO₂ and TiO₂, is used as a front surface mirror generally used. This film structure is, however, inferior in abrasion resistance property. In case that the surface has been stained, wiping with cloth or the like is not possible.

As one for solving this defect, Patent Publication 4 proposes a front surface mirror in which thin films have been formed on the substrate in the order of Al, SiO₂, TiO₂ and SixNy. The front surface mirror of this film structure is improved in abrasion resistance. The structure of the A1 film is, however, not improved. Therefore, sufficient hardness and durability have not been obtained.

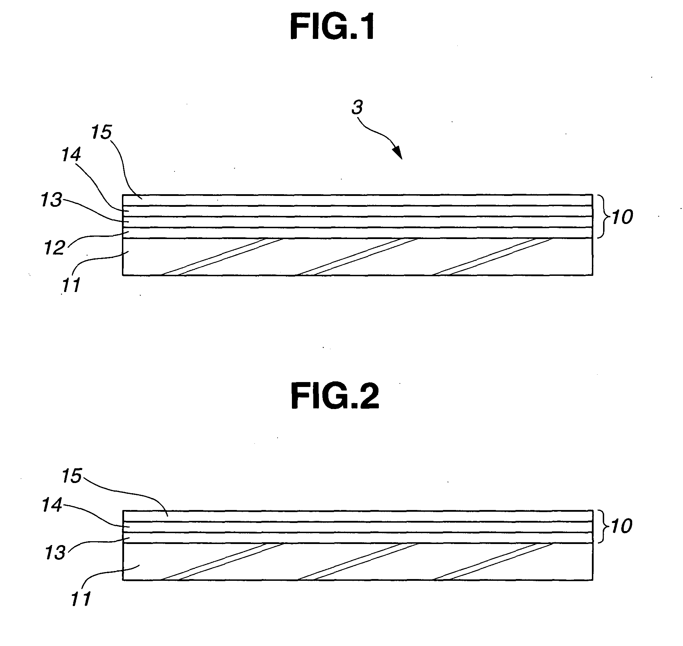

Furthermore, as a recent market demand, there is a demand for thinning the depth d of a projection television as shown in Fig. 1 to the extent that is the same as that of a plasma display panel (PDP) or liquid crystal display (LCD). In order to solve this, there has been a design trend of increasing the reflection angle between the light source and the front surface mirror.

The increase of the reflection angle in the Al front surface reflective mirror caused a problem that the display brightness of screen is lowered by the decrease of the visible light reflectance and a problem that the reflectance of short wavelength region and long wavelength region is lowered to incline the color tone toward red color or blue color, thereby not reproducing the color of the image of the image projection apparatus 2. Patent Publication 1: Japanese Patent Application Publication 2001-226765 Patent Publication 2: Japanese Patent Application Publication 6-51110 Patent Publication 3: Japanese Patent Application Publication 6-130210 Patent Publication 4: Japanese Patent Application Publication 6-130210

### SUMMARY OF THE INVENTION

A front surface mirror having an Al film formed on the glass substrate is weak in adhesion between the glass substrate and the Al film, resulting in insufficient durability with respect to hardness, high temperature resistance, humidity resistance and salt water resistance. Thus, it has been difficult to use it for a reflective mirror of rear projection television.

Furthermore, it has a defect that the reflectance is low in the visible light entire region (400-700nm), in case that the reflective angle is large. Thus, it has been difficult to shorten the depth of a rear projection television by increasing the reflective angle of the front surface mirror.

It is a task of the present invention to provide a front surface mirror that solves such problems of durability and reflectance.

According to the present invention, there is provided a front surface mirror used for a rear projection television, in which a metal film and a metal oxide film are formed on a glass substrate in this order, the front surface mirror being characterized in that a surface of the glass substrate is reformed by ion etching and that the metal film is an Al film.

### BRIEF DESCRIPTION OF THE DRAWINGS

Fig. 1 is a schematic sectional view showing a film structure of front surface mirrors of Example 1 and Comparative Example 1 of the present invention;
Fig. 2 is a schematic sectional view showing a film structure of a front surface mirror of Example 2 of the present invention; and
Fig. 3 is a schematic view showing a structure of a rear projection television.

### DETAILED DESCRIPTION

A front surface mirror of the present invention makes it possible to provide a front surface mirror that has a high reflectance in the visible light entire region in the case of a large reflective angle necessary for the rear projection television and that is superior in durability.

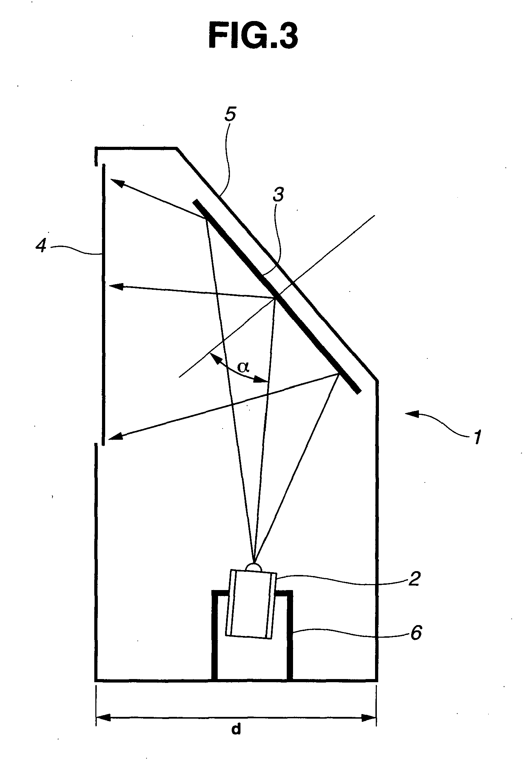

Fig. 3 is a schematic view showing a structure of a rear projection television 1, in which a front surface mirror of the present invention is used. The rear projection television 1 is mainly formed of an image projector 2, a reflective mirror 3 for reflecting the image projected from the projector 2, a screen 4 for projecting thereon the image reflected by the reflective mirror 3, and the like, in a casing 5. The projector 2 is formed of a display apparatus, such as CRT, and an optical system for projecting the image.

In order to decrease the depth d of the rear projection television, it is desirable to set the incidence angle α of the light rays of the display image at around the center of the reflective mirror at 45±25 degrees. Regarding the front surface mirror reflectance, it is desirable that the reflectance is large at an incidence angle of 45 degrees.

Regarding the film structure 10 of the front surface mirror of the present invention, it is a front surface mirror, as shown in Fig. 1, in which Al film 13, SiO₂ film 14, and Nb₂O₅ film 15 are formed in this order on a glass substrate by a physical vapor deposition method, or a front surface mirror, as shown in Fig. 2, in which SiO₂ film 12, Al film 13, SiO₂ film 14, and Nb₂O₅ film 15 are formed in this order on a glass substrate by a physical vapor deposition method.

As the glass substrate 11, one having a glass surface, on which A1 film 13 or SiO₂ film 12 is formed, which has been subjected to ion etching treatment, prior to the film formation, is used.

As the glass substrate 11, it is possible to use a plate glass that is produced by float method. It is optional to use a so-called high flatness glass having less undulation of surface or a polished glass superior in flatness.

As the ion etching apparatus, one used for apparatuses for producing LSI and the like is used. An inert gas of a pressure of 1-100Pa is introduced under an evacuated condition. Ions are generated in a vacuum by using a power supply such as high frequency. The surface of the glass is thinly etched and reformed by colliding the ions at high speed against the glass. This etched glass surface is very high in activity. It is possible to very compactly and orderly arrange the crystal structure of the Al film that is formed on this glass surface. As the conditions of this treatment, it is preferable that the voltage of the ion etching is 600V or greater, that its treatment time is 3 seconds or longer, and that a gas mixture of oxygen and argon is used as the activated gas.

As the physical vapor deposition method, it is possible to use a method such as sputtering method, vacuum vapor deposition method, electron beam deposition method or the like. In particular, sputtering method is recommended in view of film formation easiness, good film adhesion, and the like.

SiO₂ film 12 on the glass surface is formed in order to further increase crystallinity of the Al film, as compared with one in which Al film 13 formed thereon is directly formed on the glass substrate. It is preferable that the thickness is 50nm or less. Furthermore, there is no particular problem, even if it is made thick to have 100nm. Crystallinity of Al is, however, almost constant, even it exceeds 50nm.

Al film 13 is a reflective film of the front surface mirror. By having a film thickness of 60nm or greater, it is possible to obtain a visible light reflectance of 90% or greater. Even if the thickness is increased in 60nm or greater, reflectance is not increased. Therefore, it suffices that the film thickness is 60nm. However, there is no particular problem even by having a thickness greater than that.

It is possible to obtain the Al film by conducting sputtering under an inert atmosphere, such as Ar gas, using an aluminum target.

As the A1 film, it is possible to use one containing 5wt% or less of at least one metal selected from Mn, Mg, Si and Nd, as an A1 corrosion resistance improvement measure. It is possible to obtain one containing Mn, Mg, Si and Nd by using a target containing Mn, Mg, Si and Nd in an aluminum target and by conducting the film formation in an inert atmosphere such as Ar gas.

If, however, Mn, Mg, Si and Nd to be contained in the Al film exceed 5wt%, crystallinity of Al is damaged, thereby lowering reflectance. Therefore, it is not preferable.

Mn, Mg, Si and Nd to be contained in the Al film for improving durability break the structure of the crystals of the Al film, resulting in lowering of reflectance. Therefore, it is preferable to lower their content as mush as possible.

SiO₂ film 14 on the Al film also has an advantageous effect of improving adhesion between Al film 13 and the uppermost film, Nb₂O₅ film 15.

By making SiO₂ film 14 have a thickness of 30nm or greater, it is possible to obtain a front surface mirror having sufficient hardness and high temperature, high humidity resistance, as compared with one in which Nb₂O₅ film has directly been formed on Al film. The thickness of SiO₂ film 14 is preferably 80±40 nm, in order to obtain the increased reflection effect of reflectance by the difference of refractive index between Nb2O5 and that.

It is possible to obtain SiO₂ film 14 by sputtering under an atmosphere containing 50-100 wt% of oxygen relative to Ar gas, using a Si target.

It is possible to obtain Nb₂O₅ film 15 by sputtering under an atmosphere containing 50-100 wt% of oxygen relative to Ar gas, using a niobium target. The film is formed for the purpose of protecting the metal film and increasing reflection.

In order to use front surface mirror 13 in a rear projection television, it is possible to obtain sufficient high temperature, high humidity resistance and abrasion resistance by setting the thickness of Nb₂O₅ 15 at 30nm or greater. The thickness of Nb₂O₅ film 15 is preferably 60±40 nm, in order to obtain the increased reflection effect of reflectance by the difference of refractive index between SiO₂ and that.

The front surface mirror of the present invention is one having an object of being used as a reflective mirror of rear projection television. In the steps for producing the front surface mirror, the surface of the glass substrate is subjected to ion etching by using a plasma etching apparatus to reform the surface of the glass substrate into a highly active surface, followed by forming an Al film thereon.

The surface of the glass substrate subjected to ion etching treatment is very high in activity. If an Al film is formed on this glass substrate subjected to ion etching treatment, it has been confirmed from the results of the peak height of X-ray diffraction that the crystal structure of the Al film formed thereon is very compact and orderly arranged and that the Al film is formed with no defect and with high density.

The measurement results of the peak heights of X-ray diffraction of Example 1, Example 2 and Comparative Example 1 are shown in Table 2. It is shown therein that the peak heights of X-ray diffraction of Examples 1 and 2 are higher than the peak height of X-ray diffraction of Comparative Example 1.

Table 1 shows the measurement results of reflectance in the visible region of Example 1, Example 2 and Comparative Example 1. As shown in Table 1, it is possible to obtain very high reflectances in the visible region (400-700nm), in which human eye is sensible, by the Al film formed on the ion-etched glass substrate of Example 1 and Example 2, with less dependence on the reflection angle, as compared with the Al film with no ion etching treatment of Comparative Example 1.

The Al film formed on the ion-etched glass is greatly superior in hardness, high-temperature resistance, high-humidity resistance, and saltwater resistance to the Al film with no ion etching treatment.

In the following, as one example of the present invention, specific examples using sputtering method are described in detail. The present invention is, however, not limited to this.

### EXAMPLE 1

Front surface mirror 3 having a film structure shown in Fig. 1 was prepared by using a washed, dried, float method, plate glass having a thickness of 3mm and a size of 600mmx600mm. All of the film formations were conducted by sputtering method. Firstly, a reactive plasma was generated by applying a voltage of 1,000v in an atmosphere of a vacuum pressure of 0.10pa with Ar 100 (sccm) and oxygen 70 (sccm), using a highfrequency power source apparatus (output: 3k, 2A) made by Schneider. While maintaining the angle between the ion etching apparatus and the glass at 45 degrees, the glass was passed below that at a speed of about 1 (mm/min) to reform the glass surface.

Then, SiO₂ film 12 of a thickness of 30nm was formed in an atmosphere of a vacuum degree of 0.18 (pa) with argon 200 (sccm) and oxygen 156 (sccm), using a MF (medium frequency) power source made by Advance Energy, and using a dual cathode having a Si target attached thereto.

Then, Al film 13 of a thickness of 80nm was formed on the SiO₂ film in an atmosphere of Ar 300 (sccm) by using the same power source and by using a dual cathode having an Al target attached thereto.

Then, SiO₂ film 14 of a thickness of 80nm was formed in an atmosphere of Ar 300 (sccm), oxygen 70 (sccm) and a pressure of 0.46 (pa) by using the same power source and the cathode and by using the Si target.

Furthermore, a Nb₂O₅ film was formed by 60nm on SiO₂ film 14 by using a Nb target. The film formation was conducted in an atmosphere of Ar 300 (sccm), oxygen 120 (sccm) and a pressure of 0.28 (pa) by using the same power source and the cathode and by using a Nb target.

Regarding the visible light reflectance of the obtained front surface mirror, reflectance by the visible light wavelengths was measured by a spectrophotometer (U-400 type, made by Hitachi Ltd.) at an incidence angle of 8 degrees. With this, as shown in Table 1, a reflectance exceeding 90% was obtained throughout the entire wavelength. In particular, the reflectance at 400nm exceeded 90%, and therefore it was a reflective mirror that was capable of truly reproducing blue color.

Furthermore, a reflectance measurement of 45 degree incidence was conducted by using an automated absolute reflection measurement apparatus V550 made by JASCO Corporation, and the results shown in Table 1 were obtained.

As shown in Table 1, reflectances of 90.0 or higher were obtained throughout the entire wavelength at a 45 degree incidence, too. Thus, it was confirmed that the reflectance did almost not change by the incidence angle.

### Durability of Reflective Mirror of Example 1

Adhesion: An adhesive tape (Scotch Mending Tape 3M#800) was stick to the film, followed by taking this out. Exfoliation of the formed film per 45mmφ and the number of pinholes (the number) were observed and measured by a microscope.

As a result, there was no exfoliation of the film, and the number of pinholes was also 0. Therefore, it was confirmed that adhesion of the film to the plate glass had no problem.

Hardness: A weight of 450g/cm² was put on the film surface with an interposal of 6 sheets of flannel. This was moved reciprocatively and slidingly by 500 times with a stroke distance of 100mm, and the change of transmittance of the sliding portion was measured. Transmittances were 0% before and after the test. Therefore, the change of transmittance by the test was 0%, too. Thus, it was confirmed that there was no problem in hardness of the film.

Humidity Resistance: A high temperature and high humidity test was conducted by allowing standing still for 24 hours in an atmosphere of 50°C and 95% RH (relative humidity). Haze and other external appearance changes of the film were observed. With this, problematic external appearance changes were not found, and it was confirmed that high temperature and high humidity resistance was sufficient.

High-temperature resistance property: A high temperature test was conducted by standing still for 24 hours in an atmosphere of 70°C. Haze and other external appearance changes of the film were observed. With this, problematic external appearance changes were not found, and it was confirmed that high temperature resistance property was sufficient.

High and low temperature resistance property: A high and low temperature cycle test was conducted by running two cycles, one cycle of which being defined as a cycle of standing still for 24 hours in an atmosphere of 40°C and 30%RH, then natural standing still for 1 hour, then standing still for 24 hours in an atmosphere of-10°C, and then natural standing still for 1 hour. Haze and other external appearance changes of the film were observed. With this, problematic external appearance changes were not found, and it was confirmed that high and low temperature cycle resistance property was sufficient.

Salt water resistance property: A salt water spraying test was conducted by standing still for 240 hours in 5% salt water atmosphere in an atmosphere of 35°C. Haze and other external appearance changes of the film were observed. With this, problematic external appearance changes were not found, and it was confirmed that salt water resistance was sufficient. This salt water spraying test is the severest test against front surface mirrors, and it is said to have no problem if it passes 24 hours in general. For a period of time that is 10 times this, deterioration is not generated in Example 1. Therefore, we can say that durability is far superior.

### EXAMPLE 2

A reflective mirror having a film structure 10 shown in Fig. 2 was prepared. The reflective mirror of Example 2 was prepared under the same conditions as those of Example 1, except in that SiO₂ film was not formed between the glass substrate and the Al film.

Regarding the visible light reflectance (incidence angle: 8 degrees) of the front surface mirror of Example 2, reflectance by the visible light wavelengths was measured by a spectrophotometer (U-400 type, made by Hitachi Ltd.). With this, a reflectance exceeding 90% was obtained throughout the entire wavelength.

Furthermore, reflectance of an incident angle of 45 degrees was measured with an automated absolute reflection measurement apparatus V550 made by JASCO Corporation. As a result, even at 45 degrees shown in Table 1, reflectances not lower than 88.0% were obtained throughout the entire wavelength.

As compared with Example 1, reflectances were lower by 0.3 to 1.5%, and it showed a reflectance characteristic comparable to that.

As a result of conducting the same durability tests as those of Example 1 against the front surface mirror of Example 2, it was confirmed that it had a sufficient durability similar to Example 1.

### COMPARATIVE EXAMPLE 1

A front surface mirror was prepared by conducting the same film formation, except in that the ion etching treatment of the glass substrate was not conducted. The same reflectance measurement and the durability tests as those of Example 1 were conducted.

The reflectance measurement results are shown in Table 1. As compared with Example 1 and Example 2, the reflectance is low in short wavelength and long wavelength. It becomes further lower in case that the angle becomes further greater.

The same durability tests as those of Example 1 were conducted on the front surface mirror of Comparative Example 1. The results were similar to those of Example 1 with respect to adhesion, humidity resistance, high temperature resistance property and high and low temperature resistance property. Although both transmittances before and after the hardness test were 0%, numerous fine scratches occurred. In the salt water resistance test, a white haze was found at the peripheral portion in seven days, and the entirety became cloudy in 10 days. Lowering of reflectance was found. Thus, the results were inferior to those of Example 1 and Example 2.

**[Table 1]**

| | Incidence Angle (°) | Wavelength (nm) | | | | | | |
|---|---|---|---|---|---|---|---|---|
| | | 400 | 450 | 500 | 550 | 600 | 650 | 700 |
| Ex. 1 | 8 | 93.9 | 96.0 | 96.5 | 95.9 | 95.0 | 93.7 | 91.4 |
| | 45 | 94.9 | 96.3 | 96.0 | 95.3 | 94.0 | 92.3 | 90.0 |
| Ex. 2 | 8 | 92.5 | 95.5 | 96.0 | 95.4 | 94.3 | 93.1 | 90.3 |
| | 45 | 94.0 | 95.8 | 95.5 | 95.0 | 93.5 | 92.0 | 88.5 |
| Com. Ex. 1 | 8 | 77.4 | 90.1 | 92.6 | 93.6 | 93.6 | 93.0 | 88.0 |
| | 45 | 74.0 | 89.9 | 91.2 | 92.9 | 92.6 | 91.4 | 85.3 |

**[Table 2]**

| | Diffraction Angle (2θ) (°) | Diffraction Strength (CPS) |
|---|---|---|
| Example 1 | 38.472 | 29.1 |
| | 44.738 | 9.5 |
| Example 2 | 38.472 | 26.0 |
| | 44.738 | 7.0 |
| Com. Ex. 1 | 38.472 | 12.0 |
| | 44.738 | 1.0 |

## Claims

1. In a front surface mirror used for a rear projection television, in which a metal film and a metal oxide film are formed on a glass substrate in this order, the front surface mirror being **characterized in that** a surface of the glass substrate is reformed by ion etching and that the metal film is an Al film.

2. A front surface mirror according to claim 1, which is **characterized in that** the metal oxide is formed by sequentially forming a SiO₂ film and Nb₂O₅ film on the Al film.

3. A front surface mirror according to claim 1 or 2, which is **characterized in that** a SiO₂ film is formed between the glass substrate and the Al film.

4. A front surface mirror according to any of claims 1 to 3, which is **characterized in that** the Al film contains 5wt% or less, relative to Al, of at least one metal selected from Mn, Mg, Si and Nd.
